(19) Europäisches Patentamt / European Patent Office / Office européen des brevets

(11) **EP 1 682 917 B1**

(12) **EUROPÄISCHE PATENTSCHRIFT**

(45) Veröffentlichungstag und Bekanntmachung des Hinweises auf die Patenterteilung:
**30.06.2010  Patentblatt 2010/26**

(51) Int Cl.:
***G01R 33/46*** *(2006.01)*

(21) Anmeldenummer: **03779852.7**

(22) Anmeldetag: **05.11.2003**

(86) Internationale Anmeldenummer:
**PCT/EP2003/012330**

(87) Internationale Veröffentlichungsnummer:
**WO 2005/052626 (09.06.2005 Gazette 2005/23)**

(54) **VERFAHREN ZUR VERIFIKATION DER KORREKTEN RÄUMLICHEN STRUKTUR VON MOLEKÜLEN MITTELS NMR-SPEKTROSKOPIE**

METHOD FOR VERIFYING THE CORRECT SPATIAL STRUCTURE OF MOLECULES BY MEANS OF NMR SPECTROSCOPY

PROCEDE DE VERIFICATION DE LA STRUCTURE SPATIALE CORRECTE DE MOLECULES PAR SPECTROSCOPIE A RESONANCE MAGNETIQUE NUCLEAIRE

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**26.07.2006  Patentblatt 2006/30**

(73) Patentinhaber: **Kalbitzer, Hans Robert**
**93053 Regensburg (DE)**

(72) Erfinder: **Kalbitzer, Hans Robert**
**93053 Regensburg (DE)**

(74) Vertreter: **Kohler Schmid Möbus**
**Patentanwälte**
**Ruppmannstraße 27**
**70565 Stuttgart (DE)**

(56) Entgegenhaltungen:
**WO-A-02/12872**

- **PAULI G F: "QNMR - A versatile concept for the validation of natural product reference compounds" PHYTOCHEMICAL ANALYSIS 2001 UNITED KINGDOM, Bd. 12, Nr. 1, 2001, Seiten 28-42, XP009025597 ISSN: 0958-0344**
- **"Production and Quality Control of Medicinal Products Derived by Recombinant DNA Technology" DIRECTIVE 75/318/EEC AS AMENDED, [Online] 1. Juni 2001 (2001-06-01), XP002269699 Gefunden im Internet: <URL: pharmacos.eudra.org/F2/eudralex/vol-3 /pdfs-en/3ab1aen.pdf> [gefunden am 2004-02-10]**
- **K.H.HAUSSER ET AL.: "NMR für Mediziner und Biologen" 1989 , SPRINGER VERLAG , BERLIN XP002269701 siehe Kapitel '2.1 Die NMR als analytische Methode', Seiten 40-53**
- **ABEYGUNAWARDANA C ET AL: "Development and validation of an NMR-based identity assay for bacterial polysaccharides" ANALYTICAL BIOCHEMISTRY 15 MAR 2000 UNITED STATES, Bd. 279, Nr. 2, 15. März 2000 (2000-03-15), Seiten 226-240, XP002269700 ISSN: 0003-2697**
- **GRONWALD W ET AL: "RFAC, a program for automated NMR R-factor estimation" JOURNAL OF BIOMOLECULAR NMR 2000 NETHERLANDS, Bd. 17, Nr. 2, 2000, Seiten 137-151, XP009025537 ISSN: 0925-2738 in der Anmeldung erwähnt**

## Beschreibung

Die vorlegende Erfindung betrifft ein Verfahren zur Verifikation der korrekten räumlichen Struktur von in Lösung vorliegenden Makromolekülen einer Testprobe mittels mehrdimensionaler NMR Spektroskopie.

Die Strukturbestimmung von Molekülen mit Hilfe der mehrdimensionalen NMR-Spektroskopie ist bekannt. Die NMR-Spektroskopie wird insbesondere zur Bestimmung der chemischen (kovalenten) Struktur kleiner Moleküle routinemäßig verwendet, um die postulierte Struktur von Naturstoffen oder Syntheseprodukten zu verifizieren, neue Stoffe zu identifizieren oder die intakte chemische Struktur nachzuweisen.

In der pharmazeutischen Industrie stellt sich ein neues Problem dann, wenn die intakte räumliche Struktur (Faltung) von Molekülen, insbesondere Makromolekülen wie Proteinen, wesentlich für die pharmakologische Wirksamkeit ist. Bei der Produktion von Pharmazeutika ist eine strikte Qualitätskontrolle notwendig, um sicherzustellen, dass das Medikament in gleichbleibend hoher Wirksamkeit zur Verfügung steht und keine Nebenwirkungen verursacht. Insbesondere bei Makromolekülen ist die Wirksamkeit nicht nur von der intakten chemischen Struktur abhängig, sondern auch mit der Einhaltung der korrekten Raumstruktur verknüpft. Die Überprüfung der Raumstruktur von Molekülen und Makromolekülen zur Qualitätskontrolle in der industriellen Produktion ist immer noch ein ungelöstes Problem.

In dem Dokument "Production and Quality Control of Medicinal Products Derived by Recombinant DNA Technology", Directive 75/318/EEC as amended, wird in Verbindung mit dem industriellen Einsatz der rekombinanten DNA-Technologie das Problem aufgeworfen, Tests zu entwickeln, die es gestatten, die Konformation von pharmakologisch wirksamen Makromolekülen zu verifizieren, wobei auch die NMR-Spektroskopie als prinzipiell dafür nützlich angesehen wird. Details der Lösung dieses Problems sind dem Dokument jedoch nicht zu entnehmen.

Aus dem Dokument Phytochem.Anal. 12 (2001) 28-42 ist ein Verfahren zur quantitativen Validierung der Struktur von pharmazeutisch wirksamen organischen Molekülen natürlichen Ursprungs mittels ein- bzw. mehrdimensionaler NMR-Spektroskopie bekannt. Dort werden jedoch keine Makromoleküle untersucht. Zudem wird keine Referenzprobe mit Molekülen, deren Struktur von der gewünschten Struktur abweicht, in die Analyse mit einbezogen und es wird keine Wahrscheinlichkeitsaussage über den Gehalt einer Probe an Molekülen mit der gewünschten Struktur getroffen.

Die Aufgabe der vorliegenden Erfindung besteht somit darin, ein Verfahren bereitzustellen, mit dem die korrekte räumliche Struktur (dreidimensionale Struktur) von Molekülen insbesondere in der industriellen Produktion schnell und kostengünstig quantitativ beurteilt werden kann.

Die Lösung besteht in einem Verfahren mit den Merkmalen des Anspruches 1. Erfindungsgemäß ist also vorgesehen, dass mittels eines oder mehrerer NMR-Spektren festgestellt wird, ob die dreidimensionale Struktur eines Testmoleküls mit derjenigen eines zuvor definierten Referenzmoleküls übereinstimmt. Um äußere Einflüsse auf die Spektren und die räumliche Struktur zu minimieren, müssen alle Schritte von der Probenherstellen bis zum Spektrenvergleich standardisiert werden. Die Standards werden in einem Protokoll definiert. Die Abarbeitung des Protokolls führt zu einer standardisierten Identifikation der NMR-Signale des Moleküls.

Damit ist es erstmals möglich, eine quantitative Aussage zu treffen, wie groß der Anteil der Moleküle mit korrekter dreidimensionaler Struktur in einer Probe ist. Je höher dieser Anteil ist, desto größer ist die Wahrscheinlichkeit, dass das Molekül, beispielsweise im pharmazeutischen Bereich, die gewünschte Wirkung aufweist Das erfindungsgemäße Verfahren erlaubt es, automatisch diese Prüfung vorzunehmen und beispielsweise Proben, bei denen der Anteil eine Substanz mit korrekter dreidimensionaler Struktur einen vorher definierten Schwellenwert unterschreitet, sofort zu verwerfen. Da ein NMR-Spektrum direkt mit der Struktur der gemessenen Probe korreliert ist, ermöglicht das efindungsgemäße Verfahren auch, die Qualität der Probe dahingehend zu differenzieren, ob gegebenenfalls vorhandene Unterschiede in der Struktur einen Bereich des Moleküls betreffen, der für die gewünschte Wirkung unerlässlich oder, im Gegensatz hierzu, vernachlässigbar ist. Im ersten Fall wird die Probe verworfen; im zweiten Fall wird die Probe beibehalten.

Vorteilhafte Weiterbildungen ergeben sich aus den Unteransprüchen. Zur NMR-Messung kommen alle Messsysteme (Messmethoden) in Frage, die Strukturinformationen registrieren und wiedergeben und ausreichend empfindlich auf Änderungen in der Struktur reagieren. Da die chemische Verschiebung sehr empfindlich auf Änderungen der Struktur reagiert, sind hier auch alle Messsysteme geeignet, die chemische Verschiebungen einzelner Atome oder Gruppen mit hoher Auflösung abbilden.

Das oder die Testspektren können entweder mit einem einzelnen Original-Referenzspektrum oder einem Satz von Original-Referenzspektren verglichen werden, die von einer oder mehreren Proben der Testsubstanz im Sollzustand (Referenzsubstanz) aufgenommen wurden. Der Vergleich kann dann also mit dem Originaldatensatz erfolgen. Als Alternative können das oder die Testspektren mit aus den Originalspektren erzeugten synthetischen Spektren oder Datensätzen verglichen werden. Im letzteren Fall können optimale Ergebnisse erzielt werden, wenn eine vollkommene Beschreibung aller Spinsysteme und der dazugehörigen dreidimensionalen Struktur vorliegt. In diesem Fall lassen sich die Spektren mit großer Präzision zurückrechnen. Synthetische Referenzspektren sind immer dann notwendig, wenn die Testspektren nicht unter identischen Bedingungen wie die Referenzspektren aufgenommen werden können. In diesem Fall können nur durch die Rückrechnung der Spektren die Unterschiede in den Messbedingungen ausgeglichen werden. Hierbei können insbesondere NOESY-artige Spektren mit dem vollständigen Relaxationsmatrixformalismus perfekt simuliert werden (vgl. Adrian Görler et al., "Relax, a flexible program for the backcalculation of NOESY spectra based on the complete-relaxation-matrix-formalism", Journal of Magnetic Resonance, 124,177-188 (1997); Adrian Görler et al., "Computer assisted assignment of 13C or 15N edited 3D-NOESY-HSQC-spectra using back calculated and experimental spectra", Journal of Magnetic Resonance 137, 39-45 (1999) ). Ein weiterer Spektrentyp, der gut simulierbar und daher für die Rückrechnung besonders geeignet ist, bildet die residualen dipolaren Kopplungen in partiell orientierten Proben ab.

Von den zu untersuchenden Molekülen können, je nach Struktur, gegebenem chemischen Aufbau und möglicher Auflösung entweder homonukleare oder heteronukleare Spektren, d.h. solche Spektren, bei denen auch andere Kerne als $^1$H nachgewiesen werden, aufgenommen werden. Die heteronuklearen Spektren können entweder an Substanzen aufgenommen werden, die die gewünschten Isotopen in natürlicher Häufigkeit enthalten oder künstlich mit diesen angereichert wurden. Es ist ferner sinnvoll, vor dem eigentlichen Vergleich der Spektren eventuell vorhandene Artefakte zu selektieren bzw. Unterschiede im Signal- zu Rauschverhältnis zwischen Referenzspektrum und Testspektrum zu quantifizieren und bei dem Vergleich zu berücksichtigen. Signal-, Artefakt- und Rauscherkennung kann bevorzugt automatisch z, B. durch eine Bayessche Analyse durchgeführt werden, so dass nur die echten Signalanteile in den Vergleich einbezogen werden müssen (vgl. Christof Antz et al., "A general Bayesian method for an automated signal class recognition in 2D NMR spectra combined with a multivariate discriminant analysis", J. Biomol. NMR 5, 287-296 (1995); Anja Carina Schulte et al., "Use of global symmetries in automated signal class recognition by a Bayesian method", Journal of Magnetic Resonance 129, 165-172 (1997)).

Der eigentliche Vergleich der Spektren findet dann dadurch statt, dass alle Signale einzeln miteinander verglichen werden. Dies geschieht mit Hilfe von Parametern, die vorher aus den experimentellen NMR-Daten in der Frequenz- oder Zeitdomäne extrahiert wurden. Diese Parameter wären typischerweise die Signalkoordinaten (chemischen Verschiebungen), die Signalintensität, die Signalwahrscheinlichkeit und das Kopplungsmuster. Quantifiziert werden kann die Übereinstimmung zum Beispiel durch die Berechnung von R-Werten (vgl. Wolfram Gronwald et al., "RFAC, a program for automated NMR-R-factor estimation", J. Biomol. NMR 17, 137-151 (zoom)).

Die Identifikation des Moleküls in der geforderten Struktur kann dann durch eine auf Eins normierte Wahrscheinlichkeit ausgedrückt werden. Die Wahrscheinlichkeitsaussage wird dadurch erreicht, dass als Referenzspektrum nicht nur Referenzsubstanzen mit der Soll-Struktur S aufgenommen werden, sondern auch Referenzsubstanzen vermessen werden, die gegenüber der Soll-Struktur eine abweichende, unerwünschte Struktur S' haben, also beispielsweise teilweise oder vollständig denaturiert sind, und gegebenenfalls auch solche, die zwar eine von der Soll-Struktur abweichende Struktur aufweisen, obwohl diese Änderung die Wirksamkeit nicht beeinträchtigt. Durch die Korrelation der zu den verschiedenen Referenzsubstanzen gehörigen R-Werte, die die Referenzsubstanzen mit den Testsubstanzen vergleichen, kann beim automatischen Vermessen der Testsubstanzen gegebenenfalls jedes Signal einer bestimmten Struktur zugeordnet und der jeweilige Anteil quantifiziert werden. Alternativ kann im Computer die räumliche Struktur variiert und eine Rückrechnung der Spektren dazu benutzt werden, um die Wahrscheinlichkeit zu ermitteln, dass das gegebene Spektrum der intakten Struktur entspricht.

Gegenstand der vorliegenden Erfindung ist auch eine Hard- und Software zur Durchführung des erfindungsgemäßen Verfahrens, insbesondere ein entsprechend eingerichteter Computer bzw. eine hierfür programmierte Software, die mit dem Computer zusammenwirkt.

Ausführungsbeispiele der vorliegenden Erfindung werden im folgenden näher erläutert.

Zur Anwendung des erfindungsgemäßen Verfahrens eignen sich alle Arten von Molekülen. Besonders geeignet ist das erfindungsgemäße Verfahren zur Strukturverifizierung von Proteinen, vor allem für den Fall, dass diese Proteine als Wirkstoffe in Medikamenten eingesetzt werden sollen, was eine zuverlässige Qualitätskontrolle notwendig macht. Wenn die Wirksamkeit der Moleküle mit ihrer Struktur korreliert ist, kann über eine quantitative Erfassung der Sfirukturqualität auf die Wirkstoffqualität rückgeschlossen werden. In der Regel sollten die Moleküle unter den Bedingungen untersucht werden, unter denen sie später eingesetzt werden sollen. Daher sollten sie im Normalfall nicht mit Isotopen angereichert werden, obwohl dies, falls zum Beispiel aus Empfindlichkeitsgründen erforderlich, natürlich vorgenommen werden kann.

Bei dem erfindungsgemäßen Verfahren wird ein automatisierter Spektrenvergleich zwischen den Referenzspektren und mindestens einem Testspektrum vorgenommen. Damit wird geklärt, inwieweit die Struktur des Testmoleküls mit der des Referenzmoleküls übereinstimmt. Um äußere Einflüsse zu minimieren, welche die Spektren unzulässig verändern könnten, werden alle Schritte von der Probenherstellung bis hin zum Spektrenvergleich in einem Protokoll definiert. Die Abarbeitung des Protokolls führt zu einer standardisierten Identifikation des Moleküls und der Bestimmung des Anteils, der in der korrekten räumlichen Struktur vorliegt. Die positive Identifkation wird in Wahrscheinlichkeiten ausgedrückt, mögliche Fehlidentifikationen durch Irrtumswahrscheinlichkeiten definiert.

Das Protokoll besteht im Ausführungsbeispiel aus sechs Teilen, in welche entsprechende Einträge vorgenommen werden. Die Einträge werden grundsätzlich mittels der Software vorgenommen, d.h. entweder automatisch von der Software generiert oder per Dialog mit dem Anwender. Die Protokolldatei sollte einem normalen Editor nicht zugänglich sein.

Jedes Teil des Protokolls enthält durch Schlüsselworte gekennzeichnete Einträge, die verschiedene Werte annehmen können. Grundsätzlich können Einträge in das Protokoll nur mittels der Software, beispielsweise über eine Eingabemaske, vorgenommen werden.

Folgende Protokollteile werden im Ausführungsbeispiel erstellt:

1. Probenherstellung, Vorbereitung für die Aufnahme des NMR-Spektrums.

In diesem Protokollteil werden die äußeren Messparameter wie pH-Wert, Messtemperatur, Reinheit der Probe, Nummer der Charge, verwendetes Lösungsmittel, Puffer etc. festgehalten. Die chemische Zusammensetzung der Probe und die kovalente Struktur des Moleküls wurden vorher beispielsweise mittels Massenspektrometrie und/oder chromatographischen Verfahren verifiziert. Wenn eine Referenz- oder eine Testprobe in die Messapparatur gegeben wird, überprüft die Software automatisch die Einhaltung dieser Rahmenbedingungen bzw. führt Konsistenzprüfungen vor, d.h. sie prüft, ob die Messwerte mit den vorgegebenen Rahmenbedingungen konsistent sind oder zu ihnen in Widerspruch stehen. Im letzteren Fall erfolgt eine Fehlermeldung. Die Software kann auch gleichzeitig den Arbeitsaufwand minimieren, in dem bestimmte Werte automatisch extrahiert werden. Bei der Aufnahme eines Spektrums sind z. B. sämtliche Prozessierungsparameter bekannt und werden von der Software für die Protokollerstellung bzw. Auswertung herangezogen. Die Software kann auch registrieren, welcher Benutzer für welche Zeit welche Messungen vorgenommen hat

2. Aufnahme des NMR-Spektrums

In diesem Teil werden vorgegebene Rahmenbedingungen der eigentlichen Messung, wie beispielsweise Pulssequenz, Feldstärke, Messparameter etc. festgehalten und von der Software automatisch bei jeder Messung eingestellt bzw. verifiziert. Sie sollten so genau wie möglich denen bei der Aufnahme entsprechen.

3. Datenprozessierung

In diesem Teil des Protokolls werden die eigentlichen Messdaten verarbeitet. Hierzu werden beispielsweise Parameter wie die benutzten Filterfunktionen, die benutzten Basislinienkorrekturen, die Größe des zu transformierenden Datensatzes und die Größe nach der Transformation abgespeichert. Die Datenprozessierung ist bspw. erläutert in Cavanagh et al. "Protein NMR spectroscopy, principles and practice", Academic Press, 1996; K.H. Hausser et H. R. Kalbitzer, "NMR in medicine and biology", Springer Verlag,1989.

4. Postprozessierung

In diesem Teil werden die Daten für den anstehenden Vergleich aufbereitet. Hierzu gehören beispielsweise die Definition von Rausch-, Signal- und Artefaktgebieten, die für die Signalklassifizierung notwendig sind (siehe oben).

5. Spektrenvergleich und Identifkation

In diesem Teil sind die eigentlichen Algorithmen bzw. die Programmplattform für den vorzunehmenden Spektrenvergleich abgelegt

6. Ausgabe des Protokolls, Archivierung

In diesem Teil wird festgelegt, in welcher Form die Software automatisch die Messergebnisse und die Vergleichsergebnisse speichert, beispielsweise auf Festplatte oder CD-Rom, und in welcher Form die Ergebnisse ausgegeben werden, beispielsweise als Text oder als graphische Darstellung.

Anschließend sollte idealer Weise eine Wahrscheinlichkeitsaussage dahingehend gemacht werden können, in welcher Menge das Molekül in seiner korrekten Struktur in der Probe vorhanden ist. Diese Aussage kann auf zweierlei Weise formuliert werden:

a) Mit einer Irrtumswahrscheinlichkeit von < a % sind > x % des Moleküls in der korrekten räumlichen Struktur vorhanden.
b) Mit einer Irrtumswahrscheinlichkeit < a % ist > y % des Moleküls in seiner korrekten räumlichen Struktur.

Da nicht alle denaturierte Moleküle im NMR-Spektrum sichtbar sind, weil beispielsweise denaturierte Moleküle miteinander aggregieren können, muss eine Absoluteichung auf einen internen Standard durchgeführt werden. Diese Absoluteichung umfasst die Quanfiifizierung der Intensitäten der Peaks und sollte am besten bei der Messung des Referenzspektrums vorgenommen werden.

Der einzelne Spektrenvergleich kann beispielsweise durch kommerzielle Software vorgenommen werden, wie sie auch für die rein qualitative Strukturanalyse, d.h. die einfache Ja/Nein-Identifikation eines Moleküls gängig sind. Ein Beispiel für eine solche Software ist die sog. Software "AMIX" der Firma Bruker.

Eine Reihe von Spektrenvergleichsmethoden ist in AMIX bereits implementiert und wird in verschiedenen Anwendungen zum Einsatz gebracht. Es ist zu untersuchen, inwieweit diese Methoden einzeln oder in Kombinationen, eventuell mit entsprechenden Erweiterungen für die Proteinidentifikation eingesetzt werden können. Eine Identifikation kann nicht stattfinden, wenn das Testspektrum sich vom Referenzspektrum unterscheidet, wobei zu definieren ist, welcher Art die Unterschiede sind (Peak Shifts, fehlende Peaks, zu viele Peaks, Linienformänderungen, Integraländerungen, etc.) und wo die Toleranzgrenze liegt. Der ideale Algorithmus sollte daher nicht nur einen nominierten Ähnlichkeitswert liefern können, sondern bei Bedarf auch eine Ja/Nein Aussage treffen können. Grundsätzlich können bei der Berechnung die beiden Spektren vertauscht werden, so dass sich einige Faktoren, z.B. zu viele Peaks oder zu wenig Peaks, zusammenfassen lassen.

Im Folgenden sollen drei verschiedene Ausführungsbeispiele a, b, c erläutert werden, die sich im wesentlichen dadurch unterscheiden, dass im Fall a die Resonanzen des Referenzspektrums nicht zugeordnet sind, in Fall b die Resonanzen des Referenzspektrums weitgehend zugeordnet sind und im Fall c zusätzlich zu b die dreidimensionale Struktur (z. Bsp. aus der Röntgenstrukturanalyse, NMR-Strukturbestimmung oder Strukturvorhersage) bekannt ist. Die spezifische Methode, die in Fall b und c zur Zuordnung der Resonanzlinien genutzt wird, ist für das beschriebene Verfahren nicht relevant, effektive Zuordnungsstrategien sind bekannt und publiziert (vgl. bspw. Cavanagh et al. "Protein NMR spectroscopy, principles and practice", Academic Press, 1996).

Für die Erstellung des Referenzspektrums oder der Referenzspektren sind nur die Teile 1 - 4 relevant. Durch Vermessung des Moleküls unter verschiedenen Bedingungen und in verschiedenen strukturellen Zuständen kann eine ganze Bibliothek von Referenzspektren angelegt werden. Hierzu werden zunächst die Spektren selbst aufgenommen und gemäß einer definierten Vorschrift optimal prozessiert . Dann wird jedem Peak im Spektrum einem Strukturelemenfi zugeordnet und in digitaler Form abgespeichert. Das Spektrum selbst setzt sich aus verschiedenen Klassen von Signalen zusammen, der Klasse $C_1$ der Signale von dem oder den Molekülen mit richtiger Struktur, der Klasse $C_2$ der Signale von gewünschten anderen Komponenten in der Referenzprobe (z. Bsp. Puffer), der Klasse $C_3$ der Signale des oder der Moleküle in unerwünschter Form, der Klasse $C_4$ der Signale anderer Substanzen (Verunreinigungen), die unerwünscht sind, der Klasse C5 der Artefaktsignale (Mess- oder Prozessierungsartefakte) und der Klasse $C_6$ der Rauschsignale. Klasse C, ist die Klasse der Signale eines Standards (z. Bsp. DSS), die den Referenzproben in fester Absolutkonzentration zugesetzt wurde. Dieser Standard dient zur Referenzierung der Frequenzskala und zur Absoluteichung der Signalintensitäten. Nur die Signale der Klassen $C_1$ und $C_3$ sind für die Beurteilung der Probenqualität relevant, die Kenntnis und Abspeicherung der Klassen $C_2$ und $C_4$ kann hilfreich sein, während die von Messung zu Messung variablen Signale der Klassen $C_5$ und $C_6$ im allgemeinen eliminiert werden. Für die Eliminierung der Signale der Klassen $C_5$ und $C_6$ eignet sich z. Bsp. eine Bayessche Analyse.

Signale der Klasse $C_1$ (und bei Vorliegen einer entsprechenden Zuordnung) der Klassen $C_2$ bis $C_4$ können in Fall b nach Ausschluss der Klassen $C_5$ und $C_6$ direkt auf Grund ihrer chemischen Verschiebung identifiziert werden (vgl. bspw. Wolfram Gronwald et al., "RFAC, a program for automated NMR-R-factor estimation", J. Biomol. NMR 17,137-151 (2000)), im Fall c auch durch Rückrechnung strukturabhängiger NMR Spektren. Im Fall a können die Signale der Klasse $C_1$ prinzipiell durch Ausschluss der anderen Signalklassen (z. Bsp. Aufnahme von Referenzspektren unter Variation der Konzentrationen der Komponenten, die die Signale der Klassen $C_2$ bis $C_4$ erzeugen).

Die Signale der Klassen $C_1$ bis $C_4$ werden separat gespeichert. Falls eine Variation der Messbedingungen in der späteren Auswertung zugelassen werden soll, auch in der Abhängigkeit von den Messbedingungen. Die Signale können entweder direkt pixel- (voxel-)weise abgespeichert werden, oder spezifische Merkmale wie Position (chemische Verschiebung), Volumen, Amplitude, Multiplettstruktur und Linienbreite können extrahiert und abgespeichert werden. Für die direkte Abspeicherung ist unter anderem eine iterative Segmentierung geeignet (Neidig, K.-P. & Kalbitzer, H. R. "Improved representation of 2D NMR spectra by local rescaling" J. Magn. Reson. 88,155-160 (1990); Geyer, M., Neidig, K.-P. & Kalbitzer, H. R. "Automated peak integration in multidimensional NMR spectra by an optimized iterative segmentation procedure", J.Magn.Reson.B 109, 31-38 (1995)). Im Fall c können alternativ alle zur Spektrensimulation wesentlichen Parameter abgespeichert werden, aus denen sich dann das/die Spektren rückrechnen lassen.

Zugleich mit diesen Daten muss die Detektionsgrenze der benutzten Referenzspektren (außer in Fall c) bestimmt werden, die im einfachsten Fall durch das globale Signal-zu-RauschVerhältnis vorgegeben ist.

Vergleich der Testspektren mit den Referenzspektren

Die Testspektren werden unter den selben Bedingungen aufgenommen und prozessiert wie die Referenzspektren. Im nächsten Schritt wird das Integral des Referenzsignals bestimmt, z. Bsp. mit der automatischen iterativen Seqmentierungsroutine (vgl. Geyer, M., Neidig, K.-P. εt Kalbitzer, H. R. "Automated peak integration in multidimensional NMR spectra by an optimized iterative segmentation procedure", J. Magn. Reson. B 109, 31-38 (1995)), wie sie im Programm AURELIA implementiert ist. Mit diesem Integral wird das Signal-zu-RauschVerhältnis bestimmt, und gleichzeitig werden alle Signalintensitäten normiert. Im Testspektrum werden mit bekannten Peakpickingroutinen (vgl. bspw. Neidig, P., Bodenmüller, H. & Kalbitzer, H. R. "Computer aided evaluation of two-dimensional NMR spectra of proteins", Biochem. Biophys. Res. Comm. 125,1143-1150 (1984)) Signale gesucht und mit der Bayesschen Analyse Signale als zugehörig zu den verschiedenen Signalklassen bewertet.

Die Signale $R_i(C_j)$ der verschiedenen Signalklassen $C_1$ bis $C_4$ des/der Referenzspektren werden im Testspektrum iterativ dadurch identifiziert, dass im ersten Schritt nach Signalen (Peakmaxima oder Peakminima) an den Stellen im Testspektrum gesucht wird, an denen in den Referenzspektren Signale zu finden sind. Ein N-dimensionaler Vektor $r_{s,l}$ (mit N gleich der Anzahl der Dimensionen des NMR-Spektrums) wird definiert, in dem ein oder mehrere Testsignale $S_{ij}$ potentiell einem gegebenen Referenzsignal $S_{R,i}$ zugehören können. Der Komponenten $r_{s,i}^k$ des Suchvektors $r_{s,t}$ sind definiert als

$$r_{s,i}^{\ k} = 2D^k + d_i^{\ k} \hspace{4cm} (1)$$

mit $D^k$ der digitalen Auflösung in der k-ten Dimension und $d_i^k$ der experimentell bestimmten oder abgeschätzten Unsicherheit der Position des Testsignals $S_i$ in der k-ten Dimension. Im allgemeinen wird mehr als ein Testsignal einem Referenzsignal zu zuordnen sein und vice versa. Die wahrscheinlichste Lösung kann durch Maximierung der zugehörigen Wahrscheinlichkeiten gefunden werden, wobei die wahrscheinlichste Lösung in einfachen Fällen durch die Permutation aller wechselseitigen Zuordnungen oder in komplizierteren Fällen durch geeignete bekannte Suchalgorithmen (z. B. simulated anealing, threshold accepting, genetische Algorithmen, neuronale Netze) gefunden werden. Diese Wahrscheinlichkeiten können entweder nichtnormiert, semiquantitativ ermittelt werden (score values) oder aus einem statistischen Ansatz gewonnen werden.

Allgemein ausgedrückt werden Eigenschaften der Referenzsignale zusammengefasst in einem Eigenschaftsvektor $\boldsymbol{E}_{R,i}$ mit den Eigenschaften der Testsignale zusammengefasst in einem Eigenschaftvektor $\boldsymbol{E}_{T,j}$ verglichen und bewertet. Geeignete Eigenschaften sind unter anderen der Abstand zwischen Referenz und Testsignal, die Volumina, die Signalform. Die Wahrscheinlichkeitsverteilungen $p(\boldsymbol{E}_{R,i})$ können entweder experimentell aus Testspektren gewonnen werden oder mit einem geeigneten Modell abgeschätzt werden.

Berechnung von Qualitätskriterien

a) Relativer Anteil an gefaltetem Protein

Der relative Anteil wohlgefalteten Proteins kann durch Vergleich der normierten Signalintensitäten der Signalklasse $C_1$ erhalten werden. Hierzu werden ein oder mehrere Spektrentypen verglichen mit dem Ziel, die Intensitäten für mehrdimensionale Signale (cross peaks) von möglichst allen den Protein zugehörigen NMR-nachweisbaren Kernen zu erhalten. Der wahrscheinliche Wert $sf$ kann analog zu dem Verfahren, das zur Berechnung von NMR-Faktoren entwickelt wurde, berechnet werden (vgl. Gronwald, W., Kirchhöfer, R. Görler, A., Kremer, W., Ganslmeier, B., Neidig, K.-P. εt Kalbitzer, H. R. "RFAC, a program for a utomated NMR-R-factor estimation", J. Biomol. NMR 17, 137-151(2000)).

$$sf = \frac{\sum\limits_{i \in C_1} I_{test,i} \cdot I_{ref,i}}{\sum\limits_{i \in C_1} I_{ref,i}^2} \hspace{3cm} (2)$$

Hierbei sind $I_{ref,i}$ die Volumina der Signale $i$ der Klasse $C_1$ der Referenzspektren und $I_{test,j}$ die Volumina der zugehörigen Signale im Testspektrum. Da einzelne Signale des Referenz- oder Testspektrums mit Signalen der Klasse $C_2$ bis $C_6$ überlagert sein können, die die Signalintensität verfälschen, wird $sf$ iterativ optimiert. Zunächst wird die Standardabweichung σ für das gegebene $sf$ berechnet als

$$\sigma = \sqrt{\frac{\sum_{i=1}^{N}\left(A_{ref,i} - sfA_{test,i}\right)^{2}}{N-1}} \tag{3}$$

und die Signale werden entfernt, für die gilt

$$\sqrt{\left(A_{ref,i} - A_{test,i}\right)^{2}} > 3\sigma \tag{4}$$

Die Schritte 1 bis drei werden iterativ wiederholt bis die Bedingung gemäß Gleichung (3) für alle Signale erfüllt ist.

Der Anteil des gefalteten Proteins $c_P$ kann dann berechnet werden als

$$c_P = s_f \frac{I_{ref,s\,tan}}{I_{test,s\,tan}} \tag{5}$$

mit $I_{ref,stan}$ und $I_{test,stan}$ den Intensitäten des Stanardsignals in Referenz- und Testprobe.

Der Fehler $\Delta c_P$ wird abgeschätzt als

$$\Delta c_P = \pm t / N\sigma \tag{6}$$

mit $t(N,p)$ als dem Korrekturwert aus der $t$-Verteilung für die Stichprobe der Größe N und mit p als der vorgegebenen Wahrscheinlichkeit.

Als Endergebnis ergibt sich, dass der Anteil des gefalteten Proteins mit der Wahrscheinlichkeit $p \geq c_P - \Delta c_P$ ist.

b) Maximaler Anteil an nicht vollständig richtig gefalteten Protein

Aus der Analyse der Referenzspektren wird ein Subset $S$ von sicheren Proteinsignalen identifiziert, die ungestört beobachtbar sind und die native Konformation vollständig beschreiben. In Fall a kann dies durch eine Bayessche Analyse erfolgen, die nur Proteinsignale mit hoher Wahrscheinlichkeit beibehält. Spektren mit teildenaturiertem Protein werden aufgenommen und die Signale identifiziert, die signifikant ihre Intensität ändert. In Fall b und c liegen die Zuordnungen vor und damit ist bekannt, ob ein Signal zum nativen Protein gehört. Für die einzelnen Signale des Referenzspektrums wird die Abweichung $\Delta A_i$ berechnet mit

$$\Delta A_i = \frac{A_{ref,i} - s_f A_{test,i}}{|A_{ref,i}|} \tag{7}$$

Der minimale Anteil $c_N$ an vollständig richtig gefalteten Protein ergibt sich dann aus

$$c_N = \min(\Delta A_i, \Delta A_i > 0) \tag{8}$$

**Patentansprüche**

1. Verfahren zur Verifikation der korrekten räumlichen Struktur S von in Lösung vorliegenden Makromolekülen einer Testprobe mittels mehrdimensionaler NMR-Spektroskopie, wobei die Makromoleküle bei gleicher chemischer Struktur unterschiedliche dreidimensionale räumliche Struktur, d.h. Faltung, haben können, wobei die pharmakologische Wirksamkeit der Makromoleküle von der korrekten räumlichen Struktur abhängt,
   wobei von einer ersten Referenzprobe mit korrekter räumlicher Struktur S der darin enthaltenen Makromoleküle mindestens ein erstes Referenzspektrum sowie von einer weiteren Referenzprobe mit einer abweichenden, unerwünschten Struktur S' der darin enthaltenen Makromoleküle mindestens ein weiteres Referenzspektrum aufgenommen oder simuliert wird, und von der zu untersuchenden Testprobe mindestens ein Testspektrum aufgenommen wird, und wobei die Referenzspektren mit dem oder den Testspektren verglichen werden, mit folgenden Verfahrensschritten:

   a. Festlegung einer standardisierten chemischen Zusammensetzung von Referenz- und Testproben und Festlegung von standardisierten Messparametern für Referenz- und Testspektren;
   b. Automatische Verifizierung der Übereinstimmung der tatsächlichen chemischen Zusammensetzung mit der standardisierten chemischen Zusammensetzung der Referenzproben;
   c. Automatische Verifizierung der korrekten Messparameter bei der Aufnahme oder Simulation der Referenzspektren;
   d. Automatische Auswertung und Speicherung der aus den Referenzspektren erhaltenen Daten, wobei geeignete Parameter der Referenzspektren, wie Signalkoordinaten, Signalintensität, Signalwahrscheinlichkeit und Kopplungsmuster, in der Frequenz- oder Zeitdomäne extrahiert werden;
   e. Automatische Verifizierung der Übereinstimmung der tatsächlichen chemischen Zusammensetzung mit der standardisierten chemischen Zusammensetzung der Testprobe;
   f. Automatische Verifizierung der korrekten Messparameter bei der Aufnahme des mindestens einen Testspektrums;
   g. Automatische Auswertung und Speicherung der aus dem mindestens einen Testspektrum erhaltenen Daten, wobei geeignete Parameter des Testspektrums wie Signalkoordinaten, Signalintensität, Signalwahrscheinlichkeit und Kopplungsmuster in der Frequenz- oder Zeitdomäne extrahiert werden,;
   h. Automatischer Vergleich der extrahierten Parameter aus den erhaltenen Daten von Testspektrum und Referenzspektren;
   i. Automatische Ermittlung desjenigen Mengenanteils der Makromoleküle der Testprobe, deren räumliche Struktur mit derjenigen der Makromoleküle in der ersten Referenzprobe übereinstimmt, wobei zur Ermittlung des Mengenanteils das Ergebnis des Vergleichs der Spektren in eine Wahrscheinlichkeitsaussage umgesetzt wird dergestalt, dass mit einer Irrtumswahrscheinlichkeit < a % ein Anteil > x % der Makromoleküle in der korrekten räumlichen Struktur vorhanden sind;

   wobei die Schritte e. bis i. beliebig oft wiederholt werden.

2. Verfahren nach Anspruch 1, **dadurch gekennzeichnet, dass** eine weitere Referenzprobe als Referenzsubstanz Makromoleküle enthält, deren räumliche Struktur von der korrekten räumlichen Struktur abweicht, wobei diese Abweichung die pharmakologische Wirksamkeit nicht beeinträchtigt.

3. Verfahren nach Anspruch 1 oder 2, **dadurch gekennzeichnet, dass** in Schritt i bei den Makromolekülen, deren räumliche Struktur mit derjenigen der ersten Referenzprobe nicht übereinstimmt, differenziert wird, ob die vorhandenen Unterschiede in der räumlichen Struktur des Makromoleküls einen Bereich betreffen, der für die pharmakologische Wirkung unerlässlich oder aber vernachlässigbar ist.

4. Verfahren nach einem der vorhergehenden Ansprüche, **dadurch gekennzeichnet, dass** vor dem Vergleich der Spektren eine Bayessche Analyse zur Signal-, Artefakt- und Rauscherkennung durchgeführt wird.

5. Verfahren nach einem der Ansprüche 1 bis 4, **dadurch gekennzeichnet, dass** das mindestens eine Testspektrum mit mindestens einem aufgenommenen Referenzspektrum verglichen wird.

6. Verfahren nach einem der Ansprüche 1 bis 4, **dadurch gekennzeichnet, dass** das mindestens eine Testspektrum mit einem simulierten Referenzspektrum verglichen wird.

7. Verfahren nach einem der Ansprüche 1 bis 6, **dadurch gekennzeichnet, dass** homonukleare Spektren aufgenommen werden.

8. Verfahren nach einem der Ansprüche 1 bis 6, **dadurch gekennzeichnet, dass** heteronukleare Spektren aufgenommen werden.

9. Verfahren nach einem der vorhergehenden Ansprüche, **dadurch gekennzeichnet, dass** zwei oder mehrere verschiedenartige Spektren aufgenommen werden.

10. Verfahren nach einem der vorhergehenden Ansprüche, **dadurch gekennzeichnet, dass** im Schritt h. vor dem eigentlichen Vergleich der Spektren eventuell vorhandene Artefakte selektiert werden.

11. Verfahren nach einem der Ansprüche 1 bis 10, **dadurch gekennzeichnet, dass** zur Erstellung der Wahrscheinlichkeitsaussage als Referenzspektren in den Schritten a. bis d. mindestens ein Spektrum der Referenzprobe mit Makromolekülen mit einer nicht gewünschten Struktur aufgenommen und die jeweiligen Strukturen mit den jeweiligen R-Werten, die die Übereinstimmung der Spektren der Testprobe mit den Spektren der Referenzprobe quantifizieren, korreliert werden.

12. Verfahren nach einem der Ansprüche 1 bis 10, **dadurch gekennzeichnet, dass** zur Erstellung der Wahrscheinlichkeitsaussage als Referenzspektren in den Schritten a. bis d. mindestens ein simuliertes Spektrum der Referenzprobe mit Makromolekülen mit einer nicht gewünschten Struktur erstellt und die jeweiligen Strukturen mit den jeweiligen R-Werten, die die Übereinstimmung der Spektren der Testprobe mit den Spektren der Referenzprobe quantifizieren, korreliert werden.

13. NMR-System mit einem Computer, eingerichtet zur Durchführung eines Verfahrens nach einem der Ansprüche 1 bis 12.

14. Computerprogramm zur Durchführung eines Verfahrens nach einem der Ansprüche 1 bis 12 nach Implementierung in einem NMR-System mit einem Computer gemäß Anspruch 13.

**Claims**

1. A method for verification of the correct spatial structure S of macro-molecules present in solution of a test sample by means of multidimensional NMR spectroscopy, wherein the macro-molecules may have different three-dimensional spatial structure, i.e. replication, with the chemical structure being identical, wherein the pharmacological efficacy of the macro-molecules is dependent of the correct spatial structure,
wherein from a first reference sample having correct spatial structure S of the macro-molecules contained therein at least one reference spectrum and from a further reference sample having a deviating, undesired structure S' of the macro-molecules contained therein at least one further reference spectrum is recorded or simulated, and from the test sample to be investigated, at least one test spectrum is recorded, and wherein the reference spectra are compared with the test spectrum or the test spectra, the method comprising the steps of:

a) determining a standardized chemical composition for the reference and test samples and determining standardized measurement parameters for reference and test spectra;
b) automatically verifying the agreement of the actual chemical composition with the standardized chemical composition of the reference samples;
c) automatically verifying the correct measurement parameters during recording or simulation of the reference spectra;
d) automatically evaluating and storing data extracted from the reference spectra, wherein suitable parameters of the reference spectra, such as signal coordinates, signal intensity, signal probability and coupling patterns are extracted in the frequency or time domain;
e) automatically verifying the agreement of the actual chemical composition with the standardized chemical composition of the test sample;
f) automatically verifying the correct measurement parameters during recordation of the at least one test spectrum;
g) automatically evaluating and storing data extracted from the at least one test spectrum, wherein suitable parameters of the test spectrum, such as signal coordinates, signal intensity, signal probability and coupling patterns are extracted in the frequency or time domain;

h) automatically comparing the parameters extracted from the data obtained from the test spectrum and the reference spectra;

i) automatically determining the fraction of macro-molecules of the test sample, the spatial structure of which agrees with that of the macro-molecules in the first reference sample, wherein, for determining the fraction, the result of the comparison of the spectra is transformed into a probability statement such that, with an error probability < a % a proportion > x % of the macro-molecules are present in the correct spatial structure;

wherein the steps e. through i. are repeated arbitrarily.

2. The method of claim 1, **characterized in that** one further reference sample contains as the reference substance macro-molecules, the spatial structure of which deviates from the correct spatial structure, with the pharmacological efficacy not being affected by this deviation.

3. The method of claim 1 or 2, **characterized in that** in step i a differentiation is made regarding the macro-molecules, the spatial structure of which does not agree with that of the first reference sample, whether the differences existing in the spatial structure of the macro-molecule relate to an area which is indispensable or negligible for the pharmacological efficacy.

4. The method according to any one of the preceding claims, **characterized in that** prior to the comparison of the spectra, Bayesian analysis is performed for signal, artefact and noise identification.

5. The method according to any one of claims 1 through 4, **characterized in that** the at least one test spectrum is compared to at least one recorded reference spectrum.

6. The method according to any one of claims 1 through 4, **characterized in that** the at least one test spectrum is compared to a simulated reference spectrum.

7. The method according to any one of claims 1 through 6, **characterized in that** the homo-nuclear spectra are recorded.

8. The method according to any one of claims 1 through 6, **characterized in that** the hetero-nuclear spectra are recorded.

9. The method according to any one of the preceding claims, **characterized in that** two or multiple different spectra are recorded.

10. The method according to any one of the preceding claims, **characterized in that** in step h., artifacts, which possibly exist, are selected prior to the actual comparison of the spectra.

11. The method according to any one of claims 1 through 10, **characterized in that** in order to determine the probability statement, at least one spectrum of the reference sample which includes macro-molecules having an undesired structure is recorded as reference spectrum in steps a. through d., and the corresponding structures are correlated with the corresponding R values quantifying the agreement of the test sample spectra with the spectra of the reference sample.

12. The method according to any one of claims 1 through 10, **characterized in that** in order to determine the probability statement, at least one simulated spectrum of the reference sample spectrum which includes macro-molecules having an undesired structure is recorded in steps a. through d., and the corresponding structures are correlated with the corresponding R values quantifying the agreement of the test sample spectra with the spectra of the reference sample.

13. An NMR system having a computer, adapted to carry out a method according to any one of claims 1 through 12.

14. A computer program for carrying out a method according to any one of claims 1 through 12 after implementation in an NMR system having a computer according to claim 13.

**EP 1 682 917 B1**

**Revendications**

1. Procédé de vérification de la structure spatiale correcte S de macromolécules d'un échantillon de test présentes en solution par spectroscopie à résonance magnétique nucléaire multidimensionnelle, les macromolécules pouvant avoir une structure spatiale tridimensionnelle différente, c'est-à-dire un repliement différent, pour une même structure chimique, l'activité pharmacologique des macromolécules dépendant de la structure spatiale correcte, au moins un premier spectre de référence d'un premier échantillon de référence avec une structure spatiale correcte S des macromolécules qu'il contient et au moins un autre spectre de référence d'un autre échantillon de référence avec une structure différente, indésirable S' des macromolécules qu'il contient étant enregistrés ou simulés, et au moins un spectre de test de l'échantillon de test à analyser étant enregistré, et les spectres de référence étant comparés avec le ou les spectres de test, comprenant les étapes de procédé suivantes :

   a. définition d'une composition chimique standardisée des échantillons de référence et de test et définition de paramètres de mesure standardisés pour les spectres de référence et de test ;
   b. vérification automatique de la concordance de la composition chimique effective avec la composition chimique standardisée des échantillons de référence ;
   c. vérification automatique des paramètres de mesure corrects lors de l'enregistrement ou de la simulation des spectres de référence ;
   d. évaluation et enregistrement automatiques des données obtenues à partir des spectres de référence, des paramètres appropriés des spectres de référence, tels que coordonnées des signaux, intensité des signaux, probabilité des signaux et modèle de couplage, étant extraits dans le domaine fréquentiel ou temporel ;
   e. vérification automatique de la concordance de la composition chimique effective avec la composition chimique standardisée de l'échantillon de test ;
   f. vérification automatique des paramètres de mesure corrects lors de l'enregistrement dudit au moins un spectre de test ;
   g. évaluation et enregistrement automatiques des données obtenues à partir dudit au moins un spectre de test, des paramètres appropriés du spectre de test, tels que coordonnées des signaux, intensité des signaux, probabilité des signaux et modèle de couplage, étant extraits dans le domaine fréquentiel ou temporel ;
   h. comparaison automatique des paramètres extraits à partir des données obtenues du spectre de test et des spectres de référence ;
   i. détermination automatique du pourcentage de macromolécules de l'échantillon de test dont la structure spatiale concorde avec celle des macromolécules dans le premier échantillon de référence, sachant que pour déterminer le pourcentage, le résultat de la comparaison des spectres est converti en une indication de probabilité selon laquelle une proportion > x % de macromolécules ayant la structure spatiale correcte est présente avec une probabilité d'erreur < a %,

   les étapes e. à i. étant répétées à volonté.

2. Procédé selon la revendication 1, **caractérisé en ce qu'**un autre échantillon de référence contient comme substance de référence des macromolécules dont la structure spatiale diffère de la structure spatiale correcte, cette différence ne compromettant pas l'activité pharmacologique.

3. Procédé selon la revendication 1 ou 2, **caractérisé en ce qu'**à l'étape i., on distingue, pour les macromolécules dont la structure spatiale ne concorde pas avec celle du premier échantillon de référence, si les différences existantes dans la structure spatiale de la macromolécule concernent une région qui est indispensable ou bien négligeable pour l'activité pharmacologique.

4. Procédé selon une des revendications précédentes, **caractérisé en ce qu'**avant la comparaison des spectres, une analyse bayésienne pour la détection de signaux, d'artefacts et de bruit est effectuée.

5. Procédé selon une des revendications 1 à 4, **caractérisé en ce que** ledit au moins un spectre de test est comparé avec au moins un spectre de référence enregistré.

6. Procédé selon une des revendications 1 à 4, **caractérisé en ce que** ledit au moins un spectre de test est comparé avec au moins un spectre de référence simulé.

7. Procédé selon une des revendications 1 à 6, **caractérisé en ce que** des spectres homonucléaires sont enregistrés.

8. Procédé selon une des revendications 1 à 6, **caractérisé en ce que** des spectres hétéronucléaires sont enregistrés.

9. Procédé selon une des revendications précédentes, **caractérisé en ce que** deux ou plusieurs spectres de nature différente sont enregistrés.

10. Procédé selon une des revendications précédentes, **caractérisé en ce qu'**à l'étape h., avant la comparaison effective des spectres, des artefacts éventuellement présents sont sélectionnés.

11. Procédé selon une des revendications 1 à 10, **caractérisé en ce que** pour établir l'indication de probabilité, au moins un spectre de l'échantillon de référence avec des macromolécules ayant une structure non désirée est enregistré comme spectre de référence aux étapes a. à d. et les structures respectives sont corrélées avec les valeurs R respectives qui quantifient la concordance des spectres de l'échantillon de test avec les spectres de l'échantillon de référence.

12. Procédé selon une des revendications 1 à 10, **caractérisé en ce que** pour établir l'indication de probabilité, au moins un spectre simulé de l'échantillon de référence avec des macromolécules ayant une structure non désirée est généré comme spectre de référence aux étapes a. à d. et les structures respectives sont corrélées avec les valeurs R respectives qui quantifient la concordance des spectres de l'échantillon de test avec les spectres de l'échantillon de référence.

13. Système de RMN comprenant un ordinateur conçu pour réaliser un procédé selon une des revendications 1 à 12.

14. Programme d'ordinateur pour réaliser un procédé selon une des revendications 1 à 12 après implémentation dans un système de RMN comprenant un ordinateur selon la revendication 13.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur

- *Phytochem.Anal.,* 2001, vol. 12, 28-42
- **Adrian Görler et al.** Relax, a flexible program for the backcalculation of NOESY spectra based on the complete-relaxation-matrix-formalism. *Journal of Magnetic Resonance,* 1997, vol. 124, 177-188
- **Adrian Görler et al.** Computer assisted assignment of C or N edited 3D-NOESY-HSQC-spectra using back calculated and experimental spectra. *Journal of Magnetic Resonance,* 1999, vol. 137, 39-45
- **Christof Antz et al.** A general Bayesian method for an automated signal class recognition in 2D NMR spectra combined with a multivariate discriminant analysis. *J. Biomol. NMR,* 1995, vol. 5, 287-296
- **Anja Carina Schulte et al.** Use of global symmetries in automated signal class recognition by a Bayesian method. *Journal of Magnetic Resonance,* 1997, vol. 129, 165-172
- **Wolfram Gronwald et al.** RFAC, a program for automated NMR-R-factor estimation. *J. Biomol. NMR,* vol. 17, 137-151
- **Cavanagh et al.** Protein NMR spectroscopy, principles and practice. Academic Press, 1996
- **K.H. Hausser ; H. R. Kalbitzer.** NMR in medicine and biology. Springer Verlag, 1989
- **Wolfram Gronwald et al.** RFAC, a program for automated NMR-R-factor estimation. *J. Biomol. NMR,* 2000, vol. 17, 137-151
- **Neidig, K.-P. ; Kalbitzer, H. R.** Improved representation of 2D NMR spectra by local rescaling. *J. Magn. Reson.,* 1990, vol. 88, 155-160
- **Geyer, M. ; Neidig, K.-P. ; Kalbitzer, H. R.** Automated peak integration in multidimensional NMR spectra by an optimized iterative segmentation procedure. *J.Magn.Reson.B,* 1995, vol. 109, 31-38
- **Geyer, M. ; Neidig, K.-P. ; Kalbitzer, H. R.** Automated peak integration in multidimensional NMR spectra by an optimized iterative segmentation procedure. *J. Magn. Reson. B,* 1995, vol. 109, 31-38
- **Neidig, P. ; Bodenmüller, H. ; Kalbitzer, H. R.** Computer aided evaluation of two-dimensional NMR spectra of proteins. *Biochem. Biophys. Res. Comm.,* 1984, vol. 125, 1143-1150
- **Gronwald, W. ; Kirchhöfer, R. ; Görler, A. ; Kremer, W. ; Ganslmeier, B. ; Neidig, K.-P. ; Kalbitzer, H. R.** RFAC, a program for a utomated NMR-R-factor estimation. *J. Biomol. NMR,* 2000, vol. 17, 137-151